Europäisches Patentamt

European Patent Office

Office européen des brevets

(11) Veröffentlichungsnummer: **0 183 933**
**B1**

(12) **EUROPÄISCHE PATENTSCHRIFT**

(45) Veröffentlichungstag der Patentschrift: **19.12.90**

(51) Int. Cl.⁵: **F 42 C 11/06**

(21) Anmeldenummer: **85112141.8**

(22) Anmeldetag: **25.09.85**

(54) Elektronischer Sprengzeitzünder.

(30) Priorität: **02.11.84 DE 3440016**

(43) Veröffentlichungstag der Anmeldung:
**11.06.86 Patentblatt 86/24**

(45) Bekanntmachung des Hinweises auf die
Patenterteilung:
**19.12.90 Patentblatt 90/51**

(84) Benannte Vertragsstaaten:
**AT BE CH DE FR GB IT LI NL SE**

(56) Entgegenhaltungen:
**GB-A-2 075 156**
**US-A-4 145 970**
**US-A-4 445 435**

(73) Patentinhaber: **Dynamit Nobel
Aktiengesellschaft
Postfach 12 61
D-5210 Troisdorf (DE)**

(72) Erfinder: **Florin, Johann, Dr.
Robert-Koch-Strasse 3
D-5210 Troisdorf (DE)**
Erfinder: **Heinemeyer, Friedrich, Dr.
Farnweg 29
D-5200 Siegburg (DE)**
Erfinder: **Röh, Peter
Augustinusstrasse 2
D-5210 Troisdorf (DE)**
Erfinder: **Steiner, Ulrich
Adenauer-Strasse 32
D-5210 Troisdorf (DE)**
Erfinder: **Uden, Edward
Gebrüderstrasse 38
D-2202 Barmstedt (DE)**

Courier Press, Leamington Spa, England.

EP 0 183 933 B1

**Beschreibung**

Die Erfindung betrifft einen elektronischen Sprengzeitzünder mit einem durch Impulse einer Zündmaschine aufladbaren Kondensator, einer die Impulse der Zündmaschine zur Einstellung einer Verzögerungszeit verwertenden integrierten Schatung, die nach dem Einstellen den Ablauf der Verzögerungszeit steuert, einer bei Ablauf der Verzögerungszeit mit Strom beaufschlagten Zündpille und mit Zünderdrähten zum Verbinden der Zündmaschine mit der integrierten Schaltung.

Es ist bekannt, anstelle der überlicherweise in Sprengzeitzündern benutzten pyrotechnischen Verzögerungsladung eine elektronische Schaltung einzusetzen, die die Verzögerungsfunktion übernimmt. Die elektronische Zeitverzögerung ist erheblich genauer und unterliegt geringeren Exemplarstreuungen als die pyrotechnische Verzögerung. Damit Sprengladungen zur Erhöhung der Sprengwirkung zeitlich gestaffelt zur Detonation gebracht werden, ist es erforderlich, die Sprengladungen mit Sprengzeitzündern auszustatten, die unterschiedliche Verzögerungszeiten bewirken. Hierzu werden sowohl die Sprengzeitzünder mit pyrotechnischer Verzögerung als auch diejenigen mit elektronischer Verzögerung bereits bei ihrer Herstellung so eingerichtet, daß die vorgesehene Verzögerungszeit bzw. eine vorgesehene Verzögerungszeitstufe entsteht. Dies bedingt jedoch eine große Vielzahl unterschiedlicher, sich durch ihre Verzögerungszeiten voneinander unterscheidender Sprengzeitzünder. Die große Typenvielfalt erfordert einen hohen Herstellungs- und Lagerhaltungsaufwand.

Die bekannten elektronischen Sprengzeitzünder unterscheiden sich von den pyrotechnischen Sprengzeitzündern dadurch, daß sie ein größeres Volumen haben und einen großen Platzaufwand erfordern und daß ihre Herstellung aufwendig und teuer ist.

Ein Verzögerungssprengzeitzünder, bei dem fünf Mikroschalter eine Zeitvorwahl erlauben, ist in der US 4 445 435 beschrieben. Obwohl damit nur wenige Zeitvorgaben möglich sind, ist der Durchmesser eines solchen Verzögerungssprengzeitzünders mehr als doppelt so groß wie bei konventionellen Sprengzündern.

Der Erfindung liegt die Aufgabe zugrunde, einen elektronischen Sprengzeitzünder der eingangs genannten Art zu schaffen, der trotz hoher Packungsdichte seiner Komponenten eine einfache Anschlußtechnik ermöglicht, mechanisch unempfindlich ist und eine hohe Funktionssicherheit hat.

Die Lösung dieser Aufgabe besteht erfindungsgemäß darin, daß die Zündpille, eine die integrierte Schaltung tragende, elektrische Leiterbahnen aufweisende Trägerplatte und der Kondensator in einer rohrförmigen Hülse hintereinander untergebracht sind, daß die Trägerplatte ein erstes Amschlußfeld mit Lötstellen zur Befestigung der Beine des Kondensators aufweist, daß an der Trägerplatte oder an einem zusätzlichen Plattenteil ein zweites Amschlußfeld mit Lötstellen zur Befestigung der aus der Hülse herausführenden Zünderdrähte vorgesehen ist, daß der Kondensator im wesentlichen koaxial in der Hülse angeordnet ist und die Trägerplatte sich — im Hülsenquerschnitt gesehen — im wesentlichen über die gesamte Innenweite der Hülse erstreckt.

Bei dem erfindungsgemäßen Sprengzeitzünder sind sämtliche Schaltungskomponenten, mit Ausnahme des Kondensators, in einem Chip untergebracht, das auf der Trägerplatte befestigt ist. Die Trägerplatte sowie der Kondensator sind in einer rohrförmigen Hülse untergebracht, die die gleiche Form und die gleichen Abmessungen haben kann wie die Hülsen pyrotechnischer Sprengzeitzünder. Die Trägerplatte, auf der die integrierte Schaltung befestigt ist, enthält Leiterbahnen, an die die Anschlußstellen der integrierten Schaltung angebondet sind. An diese Trägerplatte werden anschließend die Beine des Kondensators angelötet, wobei Kondensator und Trägerplatte entlang einer gemeinsamen Achse ausgerichtet sind. Der Kondensator ist also an einem Ende der Trägerplatte befestigt. Durch das Anlöten wird sowohl der elektrische Anschluß als auch die mechanische Befestigung zwischen Trägerplatte und Kondensator bewirkt. Die Trägerplatte bildet zusammen mit dem Kondensator eine schmale, langgestreckte Baugruppe, die der Form der schmalen Hülse weitgehend angepaßt ist. Dadurch entsteht eine kompakte schmale Bauweise. Der Kondensator ist mit seinen Beinen, die eine geringe Länge haben können, auf Leiterbahnen der Trägerplatte angelötet. Der Kondensator ist in Bezug auf die Trägerplatte nicht aufrechtstehend, sondern liegend angeordnet, wobei die Beine parallel zur Trägerplatte verlaufen. Dadurch lassen sich relativ lange Lötverbindungen herstellen, mit der Folge einer hohen Festigkeit der Lötverbindung und einer hohen Sicherheit gegen Stöße und Vibrationen.

Gemäß einer bevorzugten Weiterbildung der Erfindung ist vorgesehen, daß ein das zweite Anschlußfeld tragendes Plattenteil über mindestens einen seitlich an dem Kondensator entlangführenden Steg mit der Trägerplatte verbunden ist. Der Steg kann mindestens eine Leiterbahn aufweisen, deren eines Ende zu einer Lötstelle des zwiten Anschlußfeldes führt und deren anderes Ende durch Bonden mit der integrierten Schaltung verbunden ist. Bei dieser Variante ist ein einziger plattenförmiger Schaltungsträger vorhanden, der aus der Trägerplatte und dem Plattenteil besteht und an dem beide Anschlußfelder vorgesehen sind. Der Steg überbrückt die Länge des Kondensators und sollte möglichst schmal sein.

Bei einer alternativen Variante der Erfindung ist das das zweite Anschluß feld tragende Plattenteil von der Trägerplatte getrennt angeordnet und die Lötstellen des zweiten Anschlußfeldes sind über Drähte, die seitlich an dem Kondensator entlangführen, mit der integrierten Schaltung verbunden. Bei dieser Variante wird die Länge des Kondensators durch dünne Drähte überbrückt, so daß der Durchmesser des Kondensators beinahe so groß gemacht werden kann wie der Innendurchmesser der Hülse.

Gemäß einer bevorzugten Ausführungsform der Erfindung ist auf der Leiterplatte ein Programmierfeld aus Leiterbahnen gebildet, das zur Einstellung wählbarer Verzögerungszeiten durch äußere Einwirkung veränderbar ist. Ein solches Programmierfeld ermöglicht es, für zahlreiche Verzögerungszeiten die gleiche Schaltung zu verwenden und erst kurz vor dem Zusammenbau des Sprengzeitzünders die gewünschte Verzögerungszeit durch Einwirkung auf das Programmierfeld zu verändern. Das Programmierfeld kann beispielsweise aus einer Matrixanordnung von Leiterbahnen bestehen, die durch Brücken verbunden oder getrennt werden können, um unterschiedliche elektrische Bit-Muster zu erzeugen, die die Verzögerungszeit bestimmen. Sprengzeitzünder mit unterschiedlichen Verzögerungszeiten unterscheiden sich nur durch ihre entsprechend modifizierten Programmierfelder. Ein Eingriff in das Innere der integrierten Schaltung ist nicht erforderlich.

Vorzugsweise sind die Leiterbahnen des Programmierfeldes mit der integrierten Schaltung derart verbunden, daß die Verzögerungszeit durch Unterbrechen einer dieser Leiterbahnen oder einer Kombination dieser Leiterbahnen veränderbar ist. Die Leiterbahnen sind hierbei auf der Trägerplatte zunächst in unversehrtem Zustand angebracht und sie können durch mechanische Einwirkung oder z.B. mittels Laserstrahldurchtrennung unterbrochen werden.

Die Erfindung bietet ferner die Möglichkeit, auf die üblicherweise verwendeten separart vorgefertigten Zündpillen zu verzichten, indem an der Trägerplatte eine Zündpille erzeugt wird. Hierzu wird ein Glühdraht unmittelbar mit Anschlußstellen der Trägerplatte verbunden.

Im folgenden werden unter Bezugnahme auf die Zeichnungen Ausführungsbeispiele der Erfindung näher erläutert.

Es zeigen:

Fig. 1 einen Längsschnitt durch einen elektronischen Sprengzeitzünder,

Fig. 2 eiem Schnitt durch den elekronischen Sprengzeitzünder rechtwinklig zu dem Schnitt der Fig. 1,

Fig. 3 in vergrößertem Maßstab eine Darstellung der Einzelheit III aus Fig. 1,

Fig. 4 eine alternative Ausführungsform der Zündpille und

Fig. 5 ein Blockschaltbild der wesentlichen Komponenten, die in der integrierten Schaltung enthalten sind.

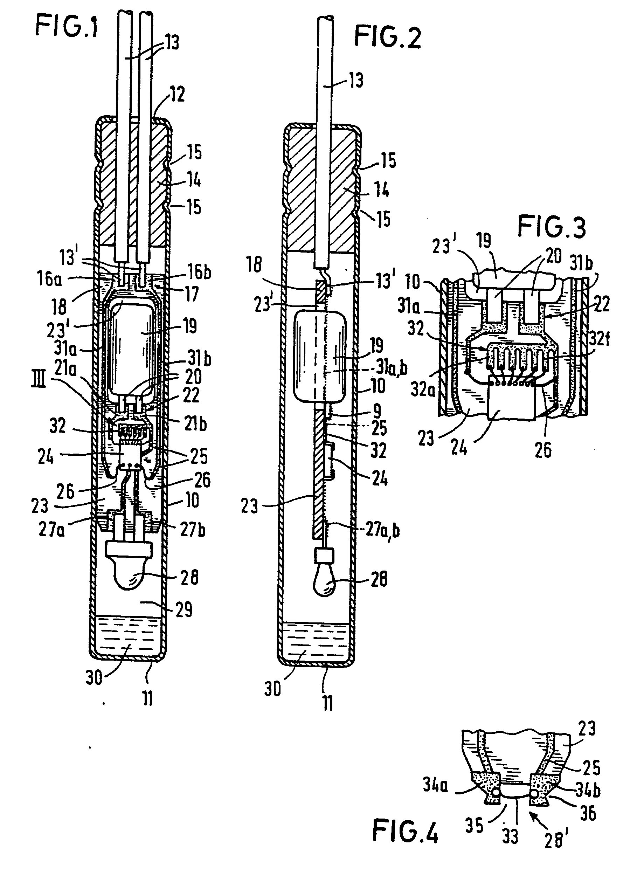

Der in den Fign. 1 bis 3 dargestellte Sprengzeitzünder weist ein langgestreckte Gehäuse in Form einer zylindrischen rohrförmigen Hülse 10 auf, die aus Metall, z. B. aus Kupfer, besteht. Die Hülse 10 ist am vorderen Ende 11 geschlossen und sie weist an ihrem rückwärtigen Ende eine Öffnung 12 auf, durch die zwei Zünderdrähte 13 von außen in das Hülseninnere hineinführen. Die Zünderdrähte 13 sind auf einem Teil ihrer Länge von einem Stopfen 14 aus Kunststoff umschlossen, der am rückwärtigen Ende der Hülse 10 durch Eindrückumgen 15 des Hülsenmantels fixiert ist. Die Zünderdrähte 13 sind jeweils mit einem Isoliermantel versehen und nur ihre vorderen Enden 13' sind abisoliert. Die aus dem Stopfen 14 herausragenden Enden 13' sind an den gegeneinanderisolierten Lötstellen 16a, 16b des Anschlußfeldes 17 angelötet. Das Anschlußfeld 17 besteht aus Leiterbahnen, die sich auf der Fläche eines Plattenteils 18 erstrecken.

Vor dem Plattenteil 18 ist in der Hülse 10 der zylindrische Kondensator 19 angeordnet, der den Querschnitt der Hülse 10 nahezu ausfüllt. Die Beine 20 des Kondensators 19 stehen von dessen vorderer Stirnseite ab. Jedes der Beine 20 ist an einer Lötstelle 21a bzw. 21b eines Anschlußfeldes 22 angelötet. Diese Lötstellen bestehen aus Leiterbahnen, die auf der Trägerplatte 23 angeordnet sind. Die Trägerplatte 23 erstreckt sich diametral in der Hülse 10. Sie besteht aus Epoxydharz, keramischem Material oder einem anderen Nichtleiter. Auf der starren Trägerplatte 23 ist die integrierte Schaltung 24 in Form eines Siliziumchips durch Kleben befestigt. Die Anschlußstellen des Chips sind mit dünnen Drähten 26 durch Bonden mit den entsprechenden Leiterbahnen 25 verbunden. Weitere Leiterbahnen, die ebenfalls Kontakt mit der integrierten Schaltung 24 haben, führen zu Anschlußstellen 27a, 27b, welche am vorderen Ende der Trägerplatte 23 vorgesehen sind. Am diese Anschlußstellen 27a, 27b werden die Beine einer Zündpille 28 angelötet, die über das vordere Ende der Trägerplatte hinaus frei in einen Hohlraum 29 der Hülse 10 hinein absteht. Im vorderen Ende der Hülse 10 bzw. im Hülsenkopf ist die Initialladung 30 untergebracht, die beim Abbrennen der Zündpille 28 gezündet wird und den umgebenden (nicht dargestellten) Sprengstoff zur Detonation bringt.

Bei dem vorliegenden Ausführungsbeispiel ist das Plattenteil 18 über zwei längslaufende Stege 31a, 31b mit der Trägerplatte 23 verbunden, so daß es mit der Trägerplatte ein einstückiges Teil bildet. Auf den Stegen 31a, 31b führen Leiterbahnen entlang, die die Lötstellen 16a, 16b mit der integrierten Schaltung 24 verbinden. Die Stege 31a, 31b umschließen eine Aussparung 23', in der der Kondensator 19 angeordnet ist. Alternativ besteht die Möglichkeit, nur einen einzigen Steg an einer Seite des Kondensators 19 zu verwenden, so daß die Aussparung 23' nach einer Seite hin geöffnet ist. In diesem Fall können die mit den Lötstellen 16a, 16b verbundenen Leiterbahnen zweckmäßigerweise auf entgegengesetzten Seiten des einzigen Steges angeordnet sein, wobei in dem Bereich der Trägerplatte 23 eine Durchkontaktierung durch die Trägerplatte hindurch vorgesehen sein muß, um die an der Unterseite der Trägerplatte befindliche Leiterbahn mit dem auf der Oberseite angeordneten Chip verbinden zu können.

Bei einer anderen (nicht dargestellten) Variante ist das Plattenteil 18 vollständig von der Trägerplatte 23 getrennt, so daß überhaupt keine Stege 31a, 31b vorgesehen sind. Die Verbindung der Lötstellen 16a, 16b 2 mit den entsprechenden Leiterbahnen der Trägerplatte 3 erfolgt dann über isolierte Drähte, die seitlich an dem Kondensator 19 entlangführen.

Auf der Trägerplatte 23 ist ein aus Leiterbahnen bestehendes Programmierfeld 32 angeordnet, das bei dem vorliegenden Ausführungsbeispiel aus sechs Leiterstreifen 32a bis 32f besteht, die an ihren einen Enden untereinander verbunden und an Massepotential gelegt sind, während die anderen Enden durch Bondungsdrähte 26 mit dem Chip der integrierten Schaltung 24 verbunden sind. Jeder einzelnen Leiterstreifen 32a bis 32f kann mit einer mechanischen Trennvorrichtung oder mit einem scharf gebündelten Laserstral durchgetrennt werden, so daß die Verbindung des betreffenden Anschlußpunktes der elektronischen Schaltung mit Massepotential aufgehoben wird, wenn eine Durchtrennung des Leiterstreifens erfolgt ist.

In Fig. 4 besteht die Zündpille 28' aus einem Glühdraht 33, der zwischen zwei Anschlußstellen 34a, 34b am vorderen Ende der Trägerplatte 23 verläuft und eine Ausnehmung 35 der Trägerplatte überbrückt. Die Aussparungen 36 dienen zur Glühdrahtführung während des Anlötens des Glühdrahtes an den Anschlußstellen.

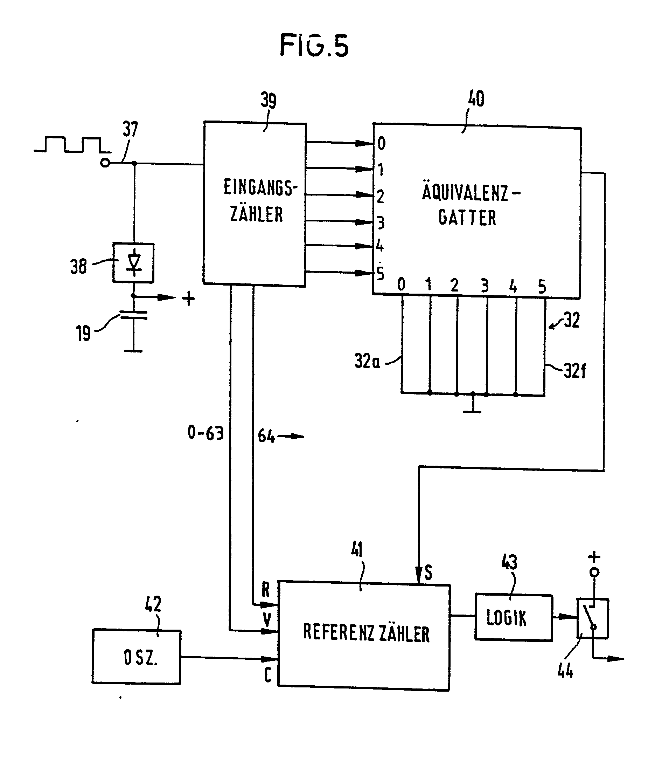

In Fig. 5 sind die wesentlichen Komponenten der integrierten Schaltung 24 dargestellt, zusammen mit dem an diese Schaltung angeschlossenen Kondensator 19 und den Leiterstreifen 32a bis 32f, die auf der Trägerplatte 23 angebracht sind.

Eine Eingangsleitung 37, die mit einem der Zünderdrähte 13 verbunden ist, wird von einer (nicht dargestellten) externen Zündmaschine mit Impulsen beaufschlagt. Diese Impulse werden über eine Gleichrichteranordnung 38 dem Kondensator 19 zugeführt, um diesen aufzuladen. Der Kondensator 19 liefert anschließend ein Spannungspotential zur Versorgung der übrigen Komponenten und schließlich auch für den Strom der Zündpille 28. Die Impulse der Eingangsleitung 37 werden einem sechsstufigen Eingangszähler 39 zugeführt, der als Binärzähler ausgebildet ist und von 0 bis 63 zählen kann. Die sechs Ausgangsleitungen des Eingangszählers 39 werden dem einen Eingang eines Äquivalenzgatters 40 zugeführt. Der andere Eingang des Äquivalenzgatters 40, der ebenfalls sechs Stellen aufweist, ist mit den sechs Leiterstreifen 32a bis 32f verbunden, deren andere Enden an Massepotential liegen. Wenn an einer Stelle des anderen Eingangs des Äquivalenzgatters Massepotential liegt, so bedeutet dies logisches " O"-Signal und wenn der Leiterstreifen unterbrochen ist, so bedeutet dies "1"-Signal.

Der Ausgang des Äquivalentsgatters 40 ist mit dem Stop-Eingang eines Referenzzählers 41 verbunden. Dieser Referenzzähler 41 ist als Vorwärts/Rückwärts-Zähler ausgebildet. Er zählt die an seinem Zähleingang C erscheinenden Impulse vorwärts, wenn an dem Vorwärtssteuereingang V ein Vorwärtssignal ansteht, und er zählt die Impulse des Zähleingangs C rückwärts, wenn an dem Rückwärtseingang R ein Rückwärtssignal ansteht. Das Vorwärtssignal wird von dem Eingangszähler 39 geliefert, solange dessen Zählerstand im Bereich von 0 bis 63 liegt. Das Rückwärtszählsignal wird von dem Eingangszähler 39 geliefert, wenn dessen Zählerstand überläuft. Der Zähleingang C des Referenzzählers 41 ist an einen Oszillator 42 angeschlossen. Der Ausgang des Referenzzählers 41 ist über eine Logikschaltung 43, die den Zählerstand "0, 0, 0 . . . 0" erkennt, mit einem elektronischen Schalter 44 verbunden, der geschlossen wird, sobald der Zählerstand des Referenzzählers 41 den Wert 0 erreicht hat. Wenn die Zündmaschine an Eingangsleitung 37 Impulse liefert, wird der Eingangszähler 39 vom Wert 0 aus hochgezählt. Wenn Koinzidenz zwischen beiden Eingängen des Äquivalenzgatters 40 besteht, liefert das Äquivalenzgatter einen Impuls an den Stop-Eingang S des Referenzzählers 41. Dieser Referenzzähler zählt bis zum Erscheinen des Stop-Signals von 0 aus die Impulse des Oszillators hoch und hält den beim Eintreffen des Stop-Signals vorhandenen Zählwert solange fest, bis an seinem Eingang R ein Rückwärtssignal erscheint. Dieses Rückwärtssignal wird geliefert, nachdem der Zählerstand des Eingangszählers den Wert 64 erreicht hat. Der Referenzzähler 41 zählt nun von dem in ihm enthaltenen Zählwert aus abwärts und wenn er den Wert 0 erreicht hat, wird über die Logikschaltung 43 der elektronische Schalter 44 geschlossen, so daß die Zündpille mit Strom versorgt wird.

Am dem Programmierfeld 32 kann durch Unterbrechen einzelner oder mehrerer Leiterstreifen 32a bis 32f jeder Wert zwischen 0 und 63 eingestellt werden. Wenn der Leiterstreifen 32a unterbrochen wird, würde das Stop-Signal für den Referenzzähler 41 bereits beim ersten Impuls erzeugt, den der Eingangszähler 39 empfängt. Wird dagegen nur der Leiterstreifen 32f unterbrochen, dann wird das Stop-Signal erzeugt, sobald der Eingangszähler 39 den 32. Impuls empfangen hat. Auf diese Weise kann am Programmierfeld 32 derjenige Zählerstand des Referenzzählers 41 programmiert werden, der die obere Grenze der Aufladung (des Hochzählens) des Referenzzählers 41 bildet. Diese Aufladung des Referenzzählers stellt ein Maß für die Zeit dar, die zum Abwärtszählen des Referenzzählers bis auf Nul erforderlich ist, also die Verzögerungszeit.

In der Praxis werden an eine einzige Zündmaschine zahlreiche Sprengzeitzünder angeschlossen, die auf unterschiedliche Verzögerungszeiten programmiert sind und die alle an ihren Eingangsleitungen 37 mit denselben Impulsen beaufschlagt werden. Die Referenzzähler der Sprengzeitzünder laden sich entsprechend der individuellen Programmierung unterschiedlich hoch auf Nachdem die Zündmaschine eine bestimmte Impulszahl (hier: 64 Impulse) abgegeben hat, ist die Aufladung der Referenzzähler sämtlicher Sprengzeitzünder beendet und danach folgt die Abwärtszählung, wobei dann die Nullstände der Referenzzähler zu unterschiedlichen Zeitpunkten erreicht werden.

## Patentansprüche

1. Elektronischer Sprengzeitzünder mit einem durch Impulse einer Zündmaschine aufladbaren Kondensator (19), einer die Impulse der Zündmaschine zur Einstellung einer Verzögerungszeit verwertenden integrierten Schaltung (24), die nach dem Einstellen der Verzögerungszeit den Ablauf dieser Verzögerungszeit steuert, einer bei Ablauf der Verzögerungszeit mit Strom beaufschlagten Zündpille (28, 28') und mit Zümderdrähten (13) zum Verbinden der Zündmaschine mit der integrierten Schaltung, dadurch gekennzeichnet, daß die Zündpille, eine die integrierte Schaltung (24) tragende, elektrische Leiterbahnen (25) aufweisende Trägerplatte (23) und der Kondensator (19) in einer rohrförmigen Hülse (10) hintereinander untergebracht sind, daß die Trägerplatte (23) ein erstes Anschlußfeld (22) mit Lötstellen (21a, 21b) zur Befestigung der Beine (20) des Kondensators (19) aufweist, daß an der Trägerplatte oder an einem zusätzlichen Plattenteil (18) ein zweites Anschlußfeld (17) mit Löststellen (16a, 16b) zur Befestigung der aus der Hülse herausführenden Zünderdrähte (13) vorgesehen ist, daß der Kondensator (19) im wesentlichen koaxial in der Hülse (10) angeordnet ist und die Trägerplatte (23) sich — im Hülsenquerschnitt gesehen — im wesentlichen über die gesamte Innenweite der Hülse erstreckt.

2. Sprengzeitzünder nach Anspruch 1, dadurch gekennzeichnet, daß ein das zweite Anschlußfeld (17) tragendes Plattenteil (18) über mindestens einen seitlich an dem Kondensator (19) entlangführenden Steg (31a, 31b) mit der Trägerplatte (23) verbunden ist.

3. Sprengzeitzünder nach Anspruch 2, dadurch gekennzeichnet, daß der Steg (31a, 31b) mindestens eine Leiterbahn (25) aufweist, deren eines Ende zu einer Lötstelle (16a, 16b) des zweiten Anschlußfeldes (17) führt und deren anderes Ende durch Bonden mit der integrierten Schaltung (24) verbunden ist.

4. Sprengzeitzünder nach Anspruch 1, dadurch gekennzeichnet, daß das das zweite Anschlußfeld (17) tragende Plattenteil (18) von der Trägerplatte (23) getrennt angeordnet ist, und daß die Lötstellen (16a, 16b) des zweiten Anschlußfeldes (17) über Drähte, die seitlich an dem Kondensator (19) entlangführen, mit der integrierten Schaltung (23) verbunden sind.

5. Sprengzeitzünder nach einem der Ansprüche 1 bis 4, dadurch gekennzeichnet, daß auf der Trägerplatte (23) ein Programmierfeld (32) aus Leiterstreifen (32a bis 32f) gebildet ist, das zur Einstellung wählbarer Verzögerungszeiten durch äußere Einwirkung veränderbar ist.

6. Sprengzeitzünder nach Anspruch 5, durch gekennzeichnet, daß die Leiterstreifen (32a bis 32f) des Programmierfeldes (32) mit der integrierten Schaltung (24) derart verbunden sind, daß die Verzögerungszeit durch Unterbrechen eines der Leiterstreifen oder einer Kombination dieser Leiterstreifen veränderbar ist.

7. Sprengzeitzünder nach einem der Ansprüche 1 bis 6, dadurch gekennzeichnet, daß die Trägerplatte (23) auf ihren beiden Seiten Leiterbahnen (25) aufweist, und daß an mindestens einer Stelle eine Durchkontaktierung von einer Leiterbahn der einen Seite zu einer Leiterbahn der anderen Seite vorhanden ist.

8. Sprengzeitzünder nach einem der Ansprüche 1 bis 7, dadurch gekennzeichnet, daß die Zündpille (28') einen Glühdraht (33) aufweist, dessen Enden unmittelbar mit Anschlußstellen (34a, 34b) der Trägerplatte (23) verbunden sind.

## Revendications

1. Détonateur électronique à temporisation comprenant un condensateur (19) pouvant être chargé par des impulsions d'une machine d'allumage, un circuit intégré (24) qui exploite les impulsions de la machine d'allumage en vue du réglage d'une durée de retardement et commande, après le réglage de la durée de retardement, l'écoulement de cette durée de retardement, une pastille d'allumage (28, 28') à laquelle est appliqué un courant lorsque la durée de retardement est écoulée, et des fils de détonateur (13) pour relier la machine d'allumage au circuit intégré, caractérisé par le fait que la pastille d'allumage, une plaque support (23) portant le circuit intégré (24) et présentant des pistes conductrices (25) électriques, et le condensateur (19) sont disposés les uns derrière les autres dans une douille (10) tubulaire, que la plaque support (23) présente un premier champ de connexion (22) avec des contacts à souder (21a, 21b) pour fixer les pattes (20) du condensateur (19), qu'il est prévu sur la plaque support ou sur une plaquette (18) supplémentaire un deuxième champ de connexion (17) avec des contacts à souder (16a, 16b) pour fixer les fils de détonateur (13) sortant de la douille, que le condensateur (19) est disposé de façon sensiblement coaxiale dans la douille (10) et la plaque support (23) s'étend — vu en coupe transversale de la douille sensiblement sur toute la largeur intérieure de la douille.

2. Détonateur selon la revendication 1, caractérisé par le fait qu'une plaquette (18) portant le deuxième champ de connexion (17) est reliée à la plaque support (23) par au moins une barrette (31a, 31b) longeant latéralement le condensateur (19).

3. Détonateur selon la revendication 2, caractérisé par le fait que la barrette (31a, 31b) présente au moins une piste conductrice (25) dont une extrémité mène à un contact à souder (16a, 16b) du deuxième champ de connexion (17) et dont l'autre extrémité est reliée par bonding au circuit intégré (24).

4. Détonateur selon la revendication 1, caractérisé par le fait que la plaquette (18) portant le deuxième chap de connexion (17) est disposée séparément de la plaque support (23), et que les contacts à souder (16a, 16b) du deuxième champ de connexion (17) sont reliés au circuit intégré (23) par des fils qui longent latéralement le condensateur (19).

5. Détonateur selon l'une des revendications 1 à 4, caractérisé par le fait que sur la plaque support (23) il est formé un champ de programmation (32) composé de bandes conductrices (32a à 32f), qui peut être modifié par une influence extérieure en vue de régler des durées de retardement sélectionnables.

6. Détonateur selon la revendication 5, caractérisé par le fait que les bandes conductrices (32a à 32f) du champ de programmation (32) sont reliées au circuit intégré (24) de telle manière que la durée de retardement puisse être modifiée par interruption d'une des bandes conductrices ou d'une combinaison de ces bandes conductrices.

7. Détonateur selon l'une des revendications 1 à 6, caractérisé par le fait que la plaque support (23) présente sur ses deux faces des pistes conductrices (25), et qu'il existe au moins en un emplacement une métallisation menant d'une piste conductrice d'une face vers une piste conductrice de l'autre face.

8. Détonateur selon l'une des revendications 1 à 7, caractérisé par le fait que la pastille d'allumage (28') présente un filament chauffant (33) dont les extrémités sont reliées directement à des bornes de connexion (34a, 34b) de la plaque support (23).

## Claims

1. Electronic explosive delay igniters with a condenser (19) chargeable by impulses from a detonating blasting machine, an integrated circuit (24) evaluating the impulses from the detonating blasting machine for setting up a delay time, which circuit controls the termination of this delay time according to the setting of the delay time, a primer capsule (28, 28') charged with current on termination of the delay time and with detonating wires (13) for connecting the detonating blasting machine with the integrated circuit, characterised in that the primer capsule, a carrier board (23) carrying the integrated circuit (24) and having electrical conductor strips (25) and the condenser (19) are accommodated behind one another in a tubular casing (10), that the carrier board (23) has a first junction panel (22) with soldering positions (21a, 21b) for fixing the legs (20) of the condenser (19), that a second junction panel (17) with soldering positions (16a, 16b) for fixing of the firing wires (13) extending from the casing is provided on the carrier board or on additional board component (18), that the condenser (19) is arranged essentially coaxially in the casing (10) and the carrier board (23) extends essentially over the entire internal width of the casing seen in the casing cross-section.

2. Explosive delay igniter according to claim 1, characterised in that a board component (18) supporting the second junction panel (17) is connected with the support plate (23) by means of at least one land (31a, 31b) extending along the condenser (19) at one side.

3. Explosive delay igniter according to claim 1 or 2, characterised in that the land (31a, 31b) possesses at least one conductor strip (25) one end of which leads to a soldering position (16a, 16b) of the second junction panel (17) and whose other end is connected by bonds with the integrated circuit (24).

4. Explosive delay igniter according to claim 1, characterised in that the board component (18) carrying the second junction panel (17) is arranged separately from the carrier board (23) and that the soldering positions (16a, 16b), of the second junction panel (17) are connected with the integrated circuit (23) by means of wires extending laterally along the condenser (19).

5. Explosive delay igniter according to one of claims 1 to 4, characterised in that a programming panel (32) formed of conductor strips (32a to 32f) is formed on the carrier board (23), which panel is alterable for setting of delay times according to choice by external action.

6. Explosive delay igniter according to claim 5, characterised in that the conductor strips (32a to 32f) of the programmable panel (32) are connected with the integrated circuit (24) in such manner that the delay time is variable by breaking one of the conductor strips or a combination of theae conductor strips.

7. Explosive delay igniter according to one of claims 1 to 6, characterised in that the carrier board (23) possesses conductor strips (25) on both its sides and that at least at one position a through contacting from a conductor strip of the one side to a second conductor strip of the other side is provided.

8. Explosive delay igniter according to one of claims 1 to 7, characterised in that the primer capsule (28') possesses an incandescent wire (33) whose ends are connected with junction positions (34a, 34b) of the carrier board (23).

FIG.1

FIG.2

FIG.3

FIG.4

# FIG.5